# EUROPEAN PATENT APPLICATION

(11) **EP 2 980 611 A1**
(43) Date of publication of application: **03.02.2016**
(21) Application number: 14776059.9
(22) Date of filing: 26.03.2014
(51) Int. Cl.: G02B 5/02, G02B 5/18, H01L 51/50, H05B 33/02

(54) **OPTICAL FILM, OPTICAL FILM MANUFACTURING METHOD AND SURFACE LIGHT-EMITTING BODY**

(30) Priority: 28.03.2013 JP 2013068439; 18.10.2013 JP 2013217470; 21.11.2013 JP 2013240801
(71) Applicant: Mitsubishi Rayon Co., Ltd., Tokyo 100-8253 (JP)
(72) Inventor: KOSHITOUGE, Haruki, Yokohama-shi, Kanagawa 230-0053 (JP); HANAFUSA, Akihiro, Toyohashi-shi, Aichi 440-8601 (JP); KURITA, Yusuke, Yokohama-shi, Kanagawa 230-0053 (JP)
(74) Representative: TBK
(86) International application number: PCT/JP2014/058626
(87) International publication number: WO 2014/157379

(57) **Abstract**

This optical film includes a diffraction grating layer made of a transparent material, and a concavoconvex surface structure layer made of a transparent material. The surface light-emitting body includes the aforementioned optical film. This optical film manufacturing method involves supplying a second active energy ray curable composition between a substrate and a mold having a diffractive grating transfer part, irradiating second active energy rays to obtain a laminate having a diffractive grating layer on convex structure transfer part, and irradiating first active energy rays.

## Description

### TECHNICAL FIELD

The present invention relates to an optical film, an optical film manufacturing method, and a surface light-emitting body.

This application is based upon and claims the benefit of priority of the prior Japanese Patent Application No. 2013-68439 filed in the Japanese Patent Office on March 28, 2013, the prior Japanese Patent Application No. 2013-217470, filed in the Japanese Patent Office on October 18, 2013, and the prior Japanese Patent Application No. 2013-240801 filed in the Japanese Patent Office on November 21, 2013, the entire contents of which are incorporated herein by reference.

### BACKGROUND ART

Among the surface light-emitting bodies, an organic EL (electroluminescence) light-emitting device is expected to be used in next-generation lighting as an alternative of a flat panel display, a fluorescent lamp, or the like.

The structure of the organic EL light-emitting device has been diversified from those having a simple structure in which only an organic thin film serving as a light-emitting layer is sandwiched between two electrodes to those having a structure which includes a light-emitting layer and multilayered organic thin films. Examples of the latter multilayered structure may include those fabricated by stacking a hole transport layer, a light-emitting layer, an electron transport layer, and a cathode on an anode provided on a glass substrate. The layers sandwiched between the anode and the cathode are all constituted by organic thin films, and the thickness of each organic thin film is significantly thin to be several tens of nm.

The organic EL light-emitting device is a stacked body of thin films, and the angle of total reflection of light between the thin films is determined by the difference in refractive index between the materials of the respective thin films. At present, approximately 80% of the light generated in the light-emitting layer is confined to the inside of the organic EL light-emitting device but it is not possible to extract the light to the outside. Specifically, the critical angle, θ_{c}, is 41.8° when the refractive index of the glass substrate is 1.5 and the refractive index of the air layer is 1.0, and the light with an angle of incidence smaller than this critical angle, θ_{c}, exits from the glass substrate to the air layer but the light with an angle of incidence greater than this critical angle, θ_{c}, is totally reflected to be confined to the inside of the glass substrate. Hence, it is desired to extract the light confined to the inside of the glass substrate on the surface of the organic EL light-emitting device to the outside of the glass substrate, namely, to improve the light extraction efficiency or the normal brightness. Hence, it is desired to extract the light confined to the inside of the glass substrate on the surface of the organic EL light-emitting device to the outside of the glass substrate, namely, to improve the light extraction efficiency or the normal brightness.

In addition, with regard to an organic EL light-emitting device that isotropically emits light, it is desired that the exiting angle dependency of the wavelength of light exited from the organic EL light-emitting device is small as well as the light extraction efficiency or the normal brightness is improved. In other words, it is desired that the difference in exiting angle depending on the wavelength is small, that is, the wavelength dependency of the distribution of light exited from the glass substrate is as small as possible when the light exited from the light-emitting layer passes through the glass substrate and exits from the glass substrate.

In order to solve the above problems, an optical film having a microlens on the light-exiting surface and a diffraction grating constituted by the air on the light incident surface is proposed in Patent Document 1. In addition, an optical film that is constituted by a resin containing fine particles and has a microlens on the light-exiting surface is proposed in Patent Document 2.

### CITATION LIST

### PATENT DOCUMENT

Patent Document 1: JP 2012-507110 W
Patent Document 2: JP 2010-212204 A

### SUMMARY OF THE INVENTION

### PROBLEM TO BE SOLVED BY THE INVENTION

However, the optical film described in Patent Document 1 requires a number of steps so that continuous production is difficult and thus the productivity is poor. In addition, in the optical film described in Patent Document 2, the light extraction efficiency or normal brightness of the surface light-emitting body is poor and the suppression of exiting angle dependency of the exited light wavelength in the surface light-emitting body is insufficient.

Accordingly, an object of the invention is to provide an optical film which achieves both an improvement in light extraction efficiency or normal brightness of a surface light-emitting body and the suppression of exiting angle dependency of the exited light wavelength in a surface light-emitting body and a surface light-emitting body which achieves both an improvement in light extraction efficiency or normal brightness and the suppression of exiting angle dependency of the exited light wavelength. In addition, another object of the invention is to provide an optical film manufacturing method excellent in productivity.

### MEANS FOR SOLVING PROBLEM

The invention relates to an optical film, an optical film manufacturing method, and a surface light-emitting body to be described below.
[1] An optical film including a surface relief structure layer that is composed of a first transparent material and has a relief structure and a diffraction grating layer composed of a second transparent material.
[2] The optical film according to [1], in which the second transparent material is a resin.
[3] The optical film according to [1] or [2], in which a refractive index of the second transparent material is from 1.30 to 1.80.
[4] The optical film according to any one of [1] to [3], in which a pitch of a diffraction grating of the diffraction grating layer is from 0.2 to 5 µm.
[5] The optical film according to any one of [1] to [4], in which a height of a diffraction grating of the diffraction grating layer is from 0.4 to 5 µm.
[6] The optical film according to any one of [1] to [5], in which the first transparent material is a resin.
[7] The optical film according to any one of [1] to [6], in which the relief structure of the surface relief structure layer is spherical.
[8] The optical film according to any one of [1] to [7], in which the surface relief structure layer further contains light-diffusing fine particles.
[9] The optical film according to [8], in which a volume average particle size of the light-diffusing fine particles is from 1 to 10 µm.
[10] The optical film according to [8] or [9], in which a content of the light-diffusing fine particles in the surface relief structure layer is from 1 to 50% by mass.
[11] The optical film according to any one of [1] to [10], in which a difference in refractive index between the second transparent material and the first transparent material is from 0.01 to 0.30.
[12] The optical film according to any one of [1] to [11], in which a ratio of a pitch of the relief structure of the surface relief structure layer to a pitch of a diffraction grating of the diffraction grating layer is from 10 to 100.
[13] The optical film according to any one of [1] to [12], in which the optical film further includes a substrate, and the diffraction grating layer and the surface relief structure layer are sequentially stacked on the substrate.
[14] A surface light-emitting body including the optical film according to any one of [1] to [13].
[15] The surface light-emitting body according to [14], in which the surface light-emitting body further includes an EL light-emitting device fabricated by sequentially stacking a cathode, a light-emitting layer, an anode, and a substrate, and the optical film is stacked on the substrate of the EL light-emitting device so that the surface relief structure layer becomes a light-exiting surface.
[16] An optical film manufacturing method including: supplying a second active energy ray-curable composition between a substrate and a die having a transfer portion of a diffraction grating and irradiating the composition with a second active energy ray to obtain a stacked body having a diffraction grating layer on the substrate; and supplying a first active energy ray-curable composition between the stacked body thus obtained and a die having a transfer portion of a relief structure and irradiating the composition with a first active energy ray.

### EFFECT OF THE INVENTION

By the optical film of the invention, it is possible to obtain a surface light-emitting body which has an excellent light extraction efficiency or normal brightness and exhibits suppressed exiting angle dependency of the exited light wavelength. In addition, the surface light-emitting body of the invention has an excellent light extraction efficiency or normal brightness and can exhibits suppressed exiting angle dependency of the exited light wavelength. Moreover, the optical film manufacturing method of the invention is excellent in productivity.

### BRIEF DESCRIPTION OF DRAWINGS

Fig. 1 is a schematic diagram illustrating an example of a cross section of the optical film of the invention;
Fig. 2A is a schematic diagram of a disposition example of a relief structure of the optical film of the invention viewed from above the optical film;
Fig. 2B is a schematic diagram of a disposition example of a relief structure of the optical film of the invention viewed from above the optical film;
Fig. 2C is a schematic diagram of a disposition example of a relief structure of the optical film of the invention viewed from above the optical film;
Fig. 2D is a schematic diagram of a disposition example of a relief structure of the optical film of the invention viewed from above the optical film;
Fig. 2E is a schematic diagram of a disposition example of a relief structure of the optical film of the invention viewed from above the optical film;
Fig. 2F is a schematic diagram of a disposition example of a relief structure of the optical film of the invention viewed from above the optical film;
Fig. 3A is a schematic diagram illustrating an example of a relief structure of the optical film of the invention;
Fig. 3B is a schematic diagram illustrating an example of a relief structure of the optical film of the invention;
Fig. 4 is a schematic diagram of an example of the optical film of the invention viewed from above the optical film;
Fig. 5 is a schematic diagram illustrating an example of the surface light-emitting body of the invention;
Fig. 6 is an image of a cross section of the optical film manufactured in Example 1 taken using a scanning microscope; and
Fig. 7 is an image of a cross section of the optical film manufactured in Example 4 taken using a scanning microscope.

### MODE(S) FOR CARRYING OUT THE INVENTION

Hereinafter, embodiments of the invention will be described with reference to the accompanying drawings, but the invention is not limited to these drawings.

### (Optical film 10)

An optical film 10 of the invention includes a surface relief structure layer that is composed of a first transparent material and has a relief structure and a diffraction grating layer composed of a second transparent material.

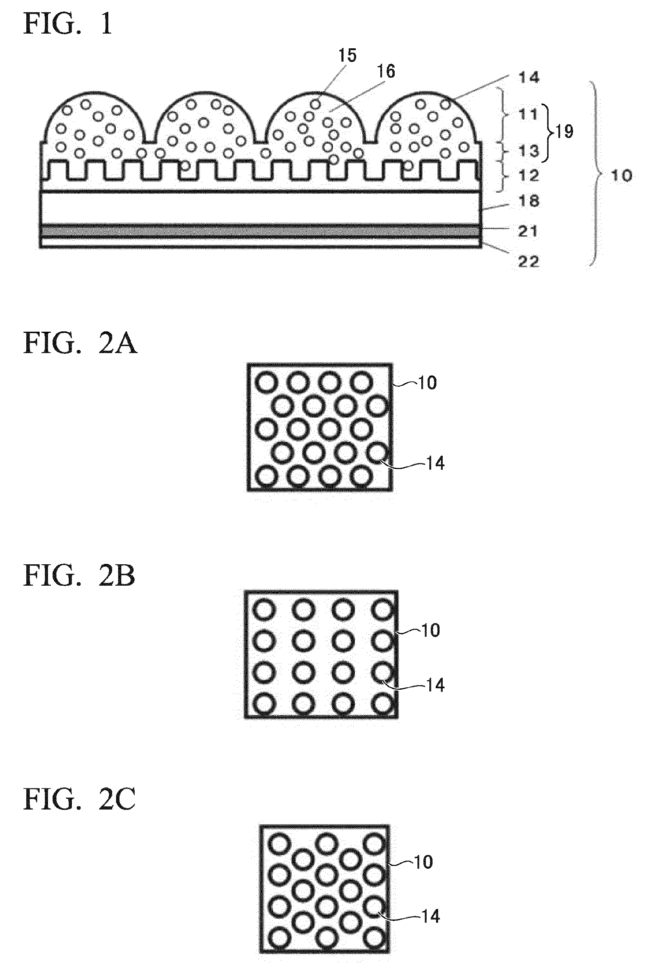

Examples of the optical film 10 of the invention may include an optical film 10 as illustrated in Fig. 1. The optical film 10 includes a substrate 18, a diffraction grating layer 12, a surface layer 19, a pressure sensitive adhesive layer 21, and a protective film 22. The surface layer 19 includes a surface relief structure layer 11 and an intermediate layer 13. The surface layer 19 contains fine particles 15 and a first resin 16. The intermediate layer 13 also includes the first resin 16 and the fine particles 15 positioned in the interspace of the grating pattern of the diffraction grating layer 12 although it will be described later. The surface relief structure layer 11 includes a relief structure 14.

The optical film 10 of the invention allows the surface light-emitting body to have an excellent light extraction efficiency or normal brightness, and thus it is preferable that the diffraction grating layer 12 and the surface relief structure layer 11 are sequentially stacked on the substrate 18. In the optical film 10, it is more preferable that the diffraction grating layer 12, the intermediate layer 13, and the surface relief structure layer 11 are sequentially stacked on the substrate 18.

### (Surface relief structure layer 11)

The protrusion (convex portion) or recess (concave portion) of the relief structure 14 having the shape to be described later is disposed on the surface relief structure layer 11.

The protrusion or recess of the relief structure layer 11 is preferably a protrusion from the viewpoint of excellent productivity of the optical film 10. In the present specification, it is simply represented as the relief structure 14 in both cases in which either of the protrusion or the recess of the relief structure 14 is present and both of them are present together.

Examples of the shape of the relief structure 14 may include a spherical segment shape, a truncated spherical segment shape, an ellipsoid spherical segment shape (a shape obtained by cutting a spheroid in one plane), a truncated ellipsoid spherical segment shape (a shape obtained by cutting a spheroid in two planes parallel to each other), a pyramidal shape, a truncated pyramidal shape, a conical shape, a truncated conical shape, a roof shape related to these (a shape in which a spherical segment shape, a truncated spherical segment shape, an ellipsoid spherical segment shape, a truncated ellipsoid spherical segment shape, a pyramidal shape, a truncated pyramidal shape, a conical shape, or a truncated conical shape extends along the bottom surface portion). These shapes of the relief structure 14 may be used singly or two or more kinds thereof may be used concurrently. Among these shapes of the relief structure 14, a spherical shape such as a spherical segment shape, a truncated spherical segment shape, an ellipsoid spherical segment shape, or a truncated ellipsoid spherical segment shape is preferable and a spherical segment shape and an ellipsoid spherical segment shape are more preferable from the viewpoint of an excellent light extraction efficiency or normal brightness of the surface light-emitting body.

Incidentally, the spherical shape may not be a perfect spherical shape but may be a substantially spherical shape. The substantially spherical shape is a shape in which the surface of a spherical shape is deviated from the surface of a virtual perfect sphere circumscribed by the spherical shape in the normal direction from the center of the virtual perfect sphere, and the amount of deviation may be from 0 to 20% with respect to the radius of the virtual perfect sphere.

In addition, in the present specification, in a case in which a shape is represented as an "ellipse", the ellipse also includes a circular shape in which a perfect circle is extended in one direction or multiple directions.

The disposition examples of the relief structure 14 are illustrated in Fig. 2A to Fig. 2F.

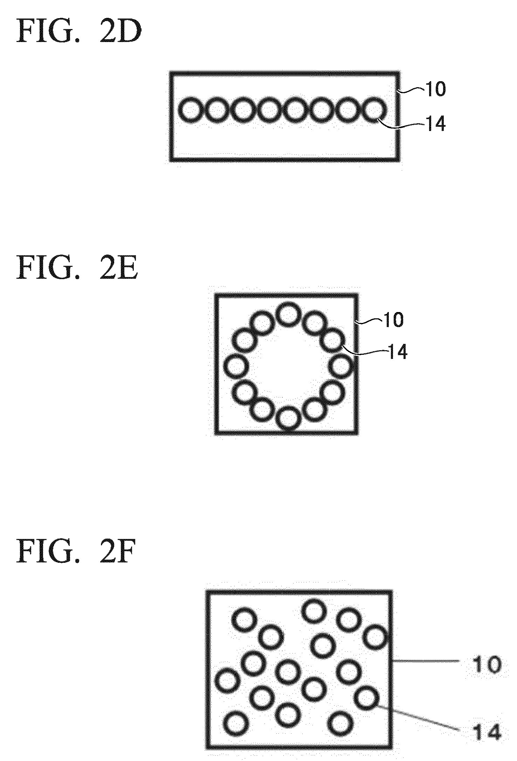

Examples of the disposition of the relief structure 14 may include a hexagonal arrangement (Fig. 2A), a rectangular arrangement (Fig. 2B), a rhombic arrangement (Fig. 2C), a linear arrangement (Fig. 2D), a circular arrangement (Fig. 2E), and a random disposition (Fig. 2F). The hexagonal arrangement means that the relief structure 14 is disposed on the respective vertices and middle points of a hexagon and the disposition of the hexagon is continuously arranged. The rectangular arrangement means that the relief structure 14 is disposed on the respective vertices of a rectangle and the disposition of the rectangle is continuously arranged. The rhombic arrangement means that the relief structure 14 is disposed on the respective vertices of a rhombus and the disposition of the rhombus is continuously arranged. The linear arrangement means that the relief structure 14 is disposed in a straight line. The circular arrangement means that the relief structure 14 is disposed along a circle.

Among these dispositions of the relief structure 14, a hexagonal arrangement, a rectangular arrangement, and a rhombic arrangement are preferable and a hexagonal arrangement and a rectangular arrangement are more preferable from the viewpoint of an excellent light extraction efficiency or normal brightness of the surface light-emitting body.

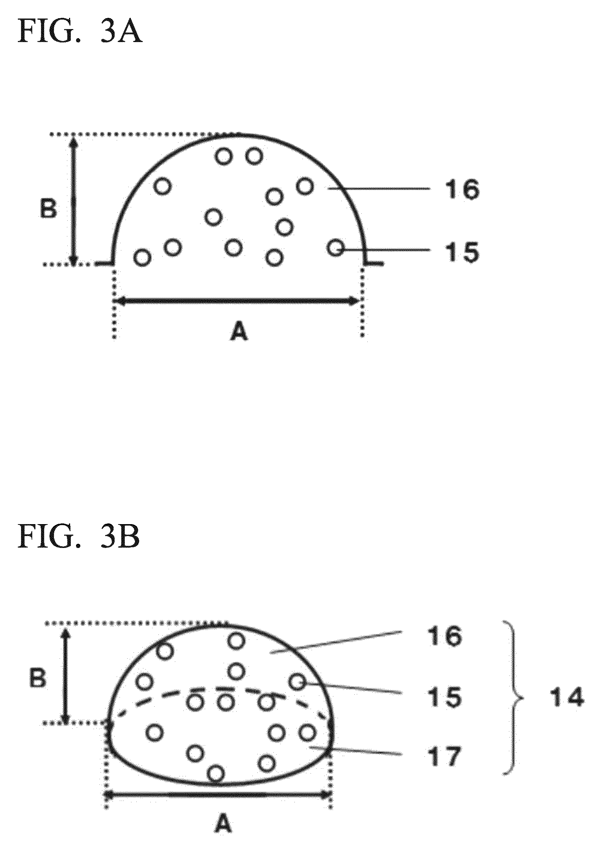

Examples of the relief structure 14 are illustrated in Fig. 3A and Fig. 3B.

In the present specification, a bottom surface portion 17 of the relief structure 14 refers to the virtual planar portion surrounded by the outer circumferential edge of the bottom portion (the contact surface with the intermediate layer 13 in the case of having the intermediate layer 13) of the relief structure 14.

In addition, in the present specification, the longest diameter, A, of the bottom surface portion 17 of the relief structure 14 refers to the length of the longest part of the bottom surface portion 17 of the relief structure 14, and the average longest diameter, Aₐᵥₑ, of the bottom surface portion 17 of the relief structure 14 is a value obtained by taking an image of the surface having the relief structure 14 of the optical film 10 using a scanning microscope, measuring the longest diameter, A, of the bottom surface portion 17 of the relief structure 14 at arbitrary five positions, and averaging the values measured.

Furthermore, in the present specification, the height, B, of the relief structure 14 refers to the height from the bottom surface portion 17 to the highest part of the relief structure 14 in the case of a protrusion structure, and it refers to the height from the bottom surface portion 17 to the lowest part of the relief structure 14 in the case of a recess structure. The average height, Bₐᵥₑ, of the relief structure 14 is a value obtained by taking an image of the cross section of the optical film 10 using a scanning microscope, measuring the height, B, of the relief structure 14 at arbitrary five positions, and averaging the values measured.

The average longest diameter, Aₐᵥₑ, of the bottom surface portion 17 of the relief structure 14 is preferably from 10 to 150 µm, more preferably from 12 to 130 µm, and even more preferably from 15 to 100 µm from the viewpoint of an excellent light extraction efficiency or normal brightness of the surface light-emitting body.

The average height, Bₐᵥₑ, of the relief structure 14 is preferably from 0.25 to 75µm, more preferably from 0.5 to 65 µm, and even more preferably from 1 to 50 µm from the viewpoint of an excellent light extraction efficiency or normal brightness of the surface light-emitting body.

The aspect ratio of the relief structure 14 is preferably from 0.3 to 1.4, more preferably from 0.35 to 1.3, and even more preferably from 0.4 to 1.0 from the viewpoint of an excellent light extraction efficiency or normal brightness of the surface light-emitting body.

Incidentally, the aspect ratio of the relief structure 14 is calculated from the "average height, Bₐᵥₑ, of relief structure 14/average longest diameter, Aₐᵥₑ, of bottom surface portion 17 of relief structure 14".

Examples of the shape of the bottom surface portion 17 of the relief structure 14 may include a circular shape and an elliptical shape. These shapes of the bottom surface portion 17 of the relief structure 14 may be used singly or two or more kinds thereof may be used concurrently. Among these shapes of the bottom surface portion 17 of the relief structure 14, a circular shape and an elliptical shape are preferable and a circular shape is more preferable from the viewpoint of an excellent light extraction efficiency or normal brightness of the surface light-emitting body.

Incidentally, the circular shape may not be a perfect circle but may be a substantially circular shape. A substantially circular shape is a shape in which the surface of a circular shape is deviated from the circumference of a virtual perfect circle circumscribed by the circular shape in the normal direction of the virtual perfect circle, and the amount of deviation may be from 0 to 20% with respect to the radius of the virtual perfect circle.

In addition, in the present specification, in a case in which a shape is represented as an "ellipse", the ellipse also includes a circular shape obtained by extending a perfect circle in one direction or multiple directions.

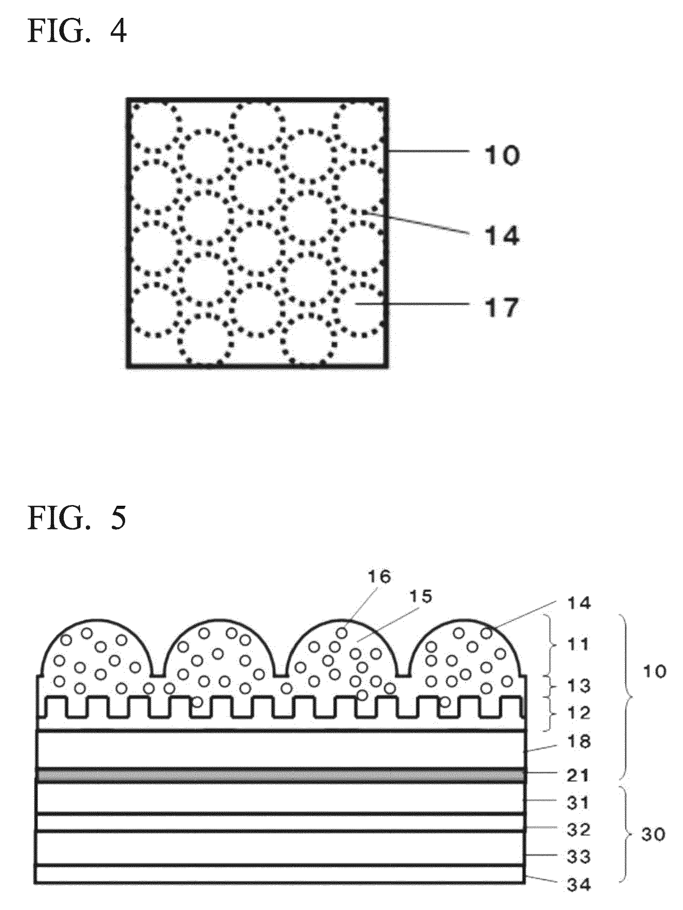

An example of the optical film viewed from above is illustrated in Fig. 4.

The proportion of the area of the bottom surface portion 17 of the relief structure 14 (the area surrounded by the dotted line in Fig. 4) to the area of the optical film 10 (the area surrounded by the solid line in Fig. 4) is preferably from 20 to 99%, more preferably from 25 to 95%, and even more preferably from 30 to 93% from the viewpoint of an excellent light extraction efficiency or normal brightness of the surface light-emitting body.

Incidentally, in a case in which all the bottom surface portions 17 of the relief structure 14 ae circular shapes having the same size, the maximum value of the proportion of the area of the bottom surface portion 17 of the relief structure 14 to the area of the optical film 10 is about 91%.

The surface relief structure layer 11 is composed of a first transparent material.

The first transparent material refers to a material that has a high light transmittance in the visible light wavelength region (approximately from 400 to 700 nm), and a resin is preferable from the viewpoint of excellent handling property. The transmittance of the first transparent material is preferably 50% or more as the value measured in conformity with JIS K7361.

### (First resin 16)

The first resin 16 is not particularly limited as long as it is a resin having a high light transmittance in the visible light wavelength region (approximately from 400 to 700 nm), and examples thereof may include an acrylic resin; a polycarbonate resin; a polyester resin such as polyethylene terephthalate, polybutylene terephthalate, and polyethylene naphthalate; a styrene resin such as polystyrene or an ABS resin; and a vinyl chloride resin. Among these first resins 16, an acrylic resin is preferable from the viewpoint of a high light transmittance in the visible light wavelength region and excellent heat resistance, mechanical properties, molding processability.

The first resin 16 is preferably a cured resin obtained by curing a first active energy ray-curable composition by irradiating with a first active energy ray from the viewpoint of excellent productivity of the optical film 10.

Examples of the first active energy ray may include ultraviolet light, an electron beam, X-ray, infrared rays, and visible light. Among these first active energy rays, ultraviolet light and an electron beam are preferable and ultraviolet light is more preferable from the viewpoint of excellent curability of the active energy ray-curable composition and being able to suppress deterioration of the optical film 10.

The first active energy ray-curable composition is not particularly limited as long as it is curable by the first active energy ray, but an active energy ray-curable composition which contains a polymerizable monomer (A), a cross-linkable monomer (B), and a polymerization initiator (C) is preferable from the viewpoint of excellent handling property and curability of the first active energy ray-curable composition and excellent physical properties such as flexibility, heat resistance, abrasion resistance, solvent resistance, and light transmitting property of the optical film 10.

Examples of the polymerizable monomer (A) may include a (meth)acrylate such as methyl (meth)acrylate, ethyl (meth)acrylate, n-propyl (meth)acrylate, iso-propyl (meth)acrylate, n-butyl (meth)acrylate, iso-butyl (meth)acrylate, sec-butyl (meth)acrylate, tert-butyl (meth)acrylate, n-hexyl (meth)acrylate, cyclohexyl (meth)acrylate, n-octyl (meth)acrylate, 2-ethylhexyl (meth)acrylate, isononyl (meth)acrylate, dodecyl (meth)acrylate, tridecyl (meth)acrylate, stearyl (meth)acrylate, alkyl (meth)acrylate, phenyl (meth)acrylate, benzyl (meth)acrylate, phenoxyethyl (meth)acrylate, isobornyl (meth)acrylate, glycidyl (meth)acrylate, tetrahydrofurfuryl (meth)acrylate, norbornyl (meth)acrylate, adamantyl (meth)acrylate, dicyclopentenyl (meth)acrylate, dicyclopentanyl (meth)acrylate, tetracyclododecanyl (meth)acrylate, cyclohexanedimethanol mono(meth)acrylate, 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, 4-hydroxybutyl (meth)acrylate, 2-methoxyethyl (meth)acrylate, 2-ethoxyethyl (meth)acrylate, 3-methoxybutyl (meth)acrylate, butoxyethyl (meth)acrylate, methoxy triethylene glycol (meth)acrylate, methoxy dipropylene glycol (meth) crylate, 2-(meth)acryloyloxymethyl-2-methylbicycloheptane, 4-(meth)acryloyloxymethyl-2-methyl-2-ethyl-1,3-dioxolane, 4-(meth)acryloyloxymethyl-2-methyl-2-isobutyl-1,3-dioxolane, trimethylolpropane formal (meth)acrylate, ethylene oxide-modified phosphoric acid (meth)acrylate, or caprolactone-modified phosphoric acid (meth)acrylate; (meth)acrylic acid; (meth)acrylonitrile; a (meth)acrylamide such as (meth)acrylamide, N-dimethyl (meth)acrylamide, N-diethyl (meth)acrylamide, N-butyl (meth)acrylamide, dimethylaminopropyl (meth)acrylamide, N-methylol(meth)acrylamide, N-methoxymethyl(meth)acrylamide, N-butoxymethyl(meth)acrylamide, (meth)acryloylmorpholine, hydroxyethyl(meth)acrylamide, or methylenebis(meth)acrylamide; an epoxy (meth)acrylate such as a compound obtained by reacting (meth)acrylic acid or any derivative thereof with a bisphenol type epoxy resin obtained by the condensation reaction between a bisphenol (bisphenol A, bisphenol F, bisphenol S, tetrabromobisphenol A, or the like) and epichlorohydrin; an aromatic vinyl compound such as styrene and α-methylstyrene; a vinyl ether such as vinyl methyl ether, vinyl ethyl ether, 2-hydroxyethyl vinyl ether; a carboxylic acid vinyl ester such as vinyl acetate or vinyl butyrate; and an olefin such as ethylene, propylene, butene, or isobutene. These polymerizable monomers (A) may be used singly or two or more kinds thereof may be used concurrently. Among these polymerizable monomers (A), a (meth) acrylate, an epoxy (meth)acrylate, an aromatic vinyl compound, and an olefin are preferable and a (meth)acrylate and an epoxy (meth)acrylate are more preferable from the viewpoint of excellent handling property and curability of the active energy ray-curable composition and excellent physical properties such as flexibility, heat resistance, abrasion resistance, solvent resistance, and light transmitting property of the optical film 10.

In the present specification, the term "(meth)acrylate" refers to an acrylate or a methacrylate.

The content of the polymerizable monomer (A) in the first active energy ray-curable composition is preferably from 0.5 to 60% by mass, more preferably from 1 to 57% by mass, and even more preferably from 2 to 55% by mass with respect to the total mass of the first active energy ray-curable composition. The handling property of the active energy ray-curable composition is excellent and the adhesive property of the optical film 10 to the substrate is excellent when the content of the polymerizable monomer (A) is 0.5% by mass or more. In addition, the crosslinkability or curability of the active energy ray-curable composition is excellent and the solvent resistance of the optical film 10 is excellent when the content of the polymerizable monomer (A) is 60% by mass or less.

Examples of the cross-linkable monomer (B) may include a hexa(meth)acrylate such as dipentaerythritol hexa(meth)acrylate or caprolactone-modified dipentaerythritol hexa(meth)acrylate; a penta(meth)acrylate such as dipentaerythritol hydroxy penta(meth)acrylate or caprolactone-modified dipentaerythritol hydroxy penta(meth)acrylate; a tetra(meth)acrylate such as ditrimethylolpropane tetra(meth)acrylate, pentaerythritol tetra(meth)acrylate, pentaerythritol ethoxy-modified tetra(meth)acrylate, dipentaerythritol hexa(meth)acrylate, dipentaerythritol penta(meth)acrylate, or tetramethylolmethane tetra(meth)acrylate; a tri(meth)acrylate such as trimethylolpropane tri(meth)acrylate, tris ethoxylated trimethylolpropane tri(meth)acrylate, pentaerythritol tri(meth)acrylate, ethoxylated pentaerythritol tri(meth)acrylate, tris(2-(meth)acryloyloxyethyl) isocyanurate, trimethylolpropane tri(meth)acrylate modified by an aliphatic hydrocarbon having from 2 to 5 carbon atoms, or isocyanuric acid ethylene oxide-modified tri(meth)acrylate; a di(meth)acrylate such as triethylene glycol di(meth)acrylate, diethylene glycol di(meth)acrylate, 1,3-butylene glycol di(meth)acrylate, 1,4-butanediol di(meth)acrylate, 1,5-pentanediol di(meth)acrylate, 1,6-hexanediol di(meth)acrylate, nonanediol di(meth)acrylate, neopentyl glycol di(meth)acrylate, methylpentanediol di(meth)acrylate, diethylpentanediol di(meth)acrylate, hydroxypivalic acid neopentyl glycol di(meth)acrylate, tetraethylene glycol di(meth)acrylate, tripropylene glycol di(meth)acrylate, polybutylene glycol di(meth)acrylate, tricyclodecanedimethanol di(meth)acrylate, 2,2-bis(4-(meth)acryloxypolyethoxyphenyl)propane, 2,2-bis(4-(meth)acryloxyethoxyphenyl)propane, 2,2-bis(4-(3-(meth)acryloxy-2-hydroxypropoxy)phenyl)propane, 1,2-bis(3-(meth)acryloxy-2-hydroxypropoxy)ethane, 1,4-bis(3-(meth)acryloxy-2-hydroxypropoxy)butane, bis(2-(meth)acryloyloxyethyl)-2-hydroxyethyl isocyanurate, cyclohexane dimethanol di(meth)acrylate, dimethylol tricyclodecane di(meth)acrylate, hydroxypivalic acid neopentyl glycol di(meth)acrylate, polyethoxylated cyclohexanedimethanol di(meth)acrylate, polypropoxylated cyclohexanedimethanol di(meth)acrylate, polyethoxylated bisphenol A di(meth)acrylate, polypropoxylated bisphenol A di(meth)acrylate, hydrogenated bisphenol A di(meth)acrylate, polyethoxylated hydrogenated bisphenol A di(meth)acrylate, polypropoxylated hydrogenated bisphenol A di(meth)acrylate, bis-phenoxyfluoreneethanol di(meth)acrylate, neopentyl glycol-modified trimethylolpropane di(meth)acrylate, di(meth)acrylate of ε-caprolactone adduct of hydroxypivalic acid neopentyl glycol, di(meth)acrylate of γ-butyrolactone adduct of hydroxypivalic acid neopentyl glycol, di(meth)acrylate of caprolactone adduct of neopentyl glycol, di(meth)acrylate of caprolactone adduct of butylene glycol, di(meth)acrylate of caprolactone adduct of cyclohexanedimethanol, di(meth)acrylate of caprolactone adduct of dicyclopentanediol, di(meth)acrylate of ethylene oxide adduct of bisphenol A, di(meth)acrylate of propylene oxide adduct of bisphenol A, di(meth)acrylate of caprolactone adduct of bisphenol A, di(meth)acrylate of caprolactone adduct of hydrogenated bisphenol A, di(meth)acrylate of caprolactone adduct of bisphenol F, or isocyanuric acid ethylene oxide-modified di(meth)acrylate; a diallyl compound such as diallyl phthalate, diallyl terephthalate, diallyl isophthalate, or diethylene glycol diallyl carbonate; allyl (meth)acrylate; divinylbenzene; methylenebisacrylamide; a polyester di(meth)acrylate such as a compound obtained by the reaction of a polyhydric alcohol (ethylene glycol, hexanediol, polyethylene glycol, or polytetramethylene glycol) and (meth)acrylic acid or any derivative thereof with a polybasic acid (phthalic acid, succinic acid, hexahydrophthalic acid, tetrahydrophthalic acid, terephthalic acid, azelaic acid, or adipic acid); a urethane polyfunctional (meth)acrylate such as a compound obtained by reacting a diisocyanate compound (tolylene diisocyanate, isophorone diisocyanate, xylene diisocyanate, dicyclohexylmethane diisocyanate, or hexamethylene diisocyanate) with a hydroxyl group-containing (meth)acrylate (a polyfunctional (meth)acrylate such as 2-hydroxyethyl (meth)acrylate, 2-hydroxypropyl (meth)acrylate, 4-hydroxybutyl (meth)acrylate, or pentaerythritol tri(meth)acrylate) or a compound obtained by adding a diisocyanate compound to the hydroxyl group of an alcohol (one kind or two or more kinds of an alkane diol, a polyether diol, a polyester diol, and a spiroglycol compound) and reacting the remaining isocyanate group with a hydroxyl group-containing (meth)acrylate; a divinyl ether such as diethylene glycol divinyl ether or triethylene glycol divinyl ether; and a diene such as butadiene, isoprene, or dimethyl butadiene. These cross-linkable monomers (B) may be used singly or two or more kinds thereof may be used concurrently. Among these cross-linkable monomers (B), a hexa(meth)acrylate, a penta(meth)acrylate, a tetra(meth)acrylate, a tri(meth)acrylate, a di(meth)acrylate, a diallyl compound, an allyl (meth)acrylate, a polyester di(meth)acrylate, and a urethane polyfunctional (meth)acrylate are preferable and a hexa(meth)acrylate, a penta(meth)acrylate, a tetra(meth)acrylate, a tri(meth)acrylate, a di(meth)acrylate, a polyester di(meth)acrylate, and a urethane polyfunctional (meth)acrylate are more preferable from the viewpoint of excellent physical properties such as flexibility, heat resistance, abrasion resistance, solvent resistance, and light transmitting property of the optical film 10.

The content of the cross-linkable monomer (B) in the first active energy ray-curable composition is preferably from 30 to 98% by mass, more preferably from 35 to 97% by mass, and even more preferably from 40 to 96% by mass with respect to the total mass of the first active energy ray-curable composition. The crosslinkability or curability of the active energy ray-curable composition is excellent and the solvent resistance of the optical film 10 is excellent when the content of the cross-linkable monomer (B) is 30% by mass or more. In addition, the flexibility of the optical film 10 is excellent when the content of the cross-linkable monomer (B) is 98% by mass or less.

Examples of the polymerization initiator (C) may include a carbonyl compound such as benzoin, benzoin methyl ether, benzoin ethyl ether, benzoin isopropyl ether, benzoin isobutyl ether, acetoin, benzil, benzophenone, p-methoxybenzophenone, 2,2-diethoxyacetophenone, and α,α-dimethoxy-α-phenylacetophenone, benzyl dimethyl ketal, methylphenyl glyoxylate, ethylphenyl glyoxylate, 4,4'-bis(dimethylamino)benzophenone, 1-hydroxycyclohexyl phenyl ketone, 2-hydroxy-2-methyl-1-phenylpropan-1-one, or 2-ethylanthraquinone; a sulfur compound such as tetramethylthiuram monosulfide or tetramethylthiuram disulfide; and an acylphosphine oxide such as 2,4,6-trimethylbenzoyldiphenylphosphine oxide or benzoyldiethoxyphosphine oxide. These polymerization initiators (C) may be used singly or two or more kinds thereof may be used concurrently. Among these polymerization initiators (C), a carbonyl compound and an acylphosphine oxide are preferable and a carbonyl compound is more preferable from the viewpoint of excellent handling property and curability of the active energy ray-curable composition and excellent light transmitting property of the optical film 10.

The content of the polymerization initiator (C) in the first active energy ray-curable composition is preferably from 0.1 to 10% by mass, more preferably from 0.5 to 8% by mass, and even more preferably from 1 to 5% by mass with respect to the total mass of the first active energy ray-curable composition. The handling property or curability of the active energy ray-curable composition is excellent when the content of the polymerization initiator (C) is 0.1% by mass or more. In addition, the light transmitting property of the optical film 10 is excellent when the content of the polymerization initiator (C) is 10% by mass or less.

The refractive index of the first resin 16 is preferably from 1.40 to 2.00, more preferably from 1.43 to 1.95, and even more preferably from 1.46 to 1.90 from the viewpoint of an excellent light extraction efficiency or normal brightness of the surface light-emitting body.

### (Fine particles 15)

The surface relief structure layer 11 may contain fine particles (light-diffusing fine particles).

The fine particles 15 are not particularly limited as long as they are fine particles having a light diffusing effect in the visible light wavelength region (approximately from 400 to 700 nm), and known fine particles can be used. The fine particles 15 may be used singly or two or more kinds thereof may be used concurrently.

Examples of the fine particles 15 may include a metal such as gold, silver, silicon, aluminum, magnesium, zirconium, titanium, zinc, germanium, indium, tin, antimony, or cerium; a metal oxide such as silicon oxide, aluminum oxide, magnesium oxide, zirconium, titanium oxide, zinc oxide, germanium oxide, indium oxide, tin oxide, indium tin oxide, antimony oxide, or cerium oxide; a metal hydroxide such as aluminum hydroxide; a metal carbonate such as magnesium carbonate; a metal nitride such as silicon nitride; and a resin such as an acrylic resin, a styrene resin, a silicone resin, a urethane resin, a melamine resin, or an epoxy resin. These materials of the fine particles 15 may be used singly or two or more kinds thereof may be used concurrently. Among these materials of the fine particles 15, silicon, aluminum, magnesium, silicon oxide, aluminum oxide, magnesium oxide, aluminum hydroxide, magnesium carbonate, an acrylic resin, a styrene resin, a silicone resin, a urethane resin, a melamine resin, and an epoxy resin are preferable and particles of silicon oxide, aluminum oxide, aluminum hydroxide, magnesium carbonate, an acrylic resin, a styrene resin, a silicone resin, a urethane resin, a melamine resin, and an epoxy resin are more preferable from the viewpoint of excellent handling property at the time of manufacturing the optical film 10.

The refractive index of the fine particles 15 is preferably from 1.30 to 2.00, more preferably from 1.35 to 1.95, and even more preferably from 1.40 to 1.90 from the viewpoint of an excellent light extraction efficiency or normal brightness of the surface light-emitting body. The refractive index of the fine particles 15 is a value measured using the sodium D line at 20°C.

The volume average particle size of the fine particles 15 is preferably from 0.5 to 20 µm, more preferably from 0.8 to 15 µm, and even more preferably from 1 to 10 µm. It is possible to effectively scatter the light in the visible wavelength region when the volume average particle size of the fine particles 15 is 0.5 µm or more. In addition, it is possible to suppress the exiting angle dependency of the exited light wavelength in the surface light-emitting body when the volume average particle size of the fine particles 15 is 20 µm or less. The volume average particle size of the fine particles 15 is a value measured by a laser diffraction and scattering method.

Examples of the shape of the fine particles 15 may include a spherical shape, a columnar shape, a cubic shape, a cuboid shape, a pyramidal shape, a conical shape, a star shape, and an irregular shape. These shapes of the fine particles 15 may be used singly or two or more kinds thereof may be used concurrently. Among these shapes of the fine particles 15, a spherical shape, a cubic shape, a cuboid shape, a pyramidal shape, and a star shape are preferable and a spherical shape is more preferable from the viewpoint of being able to effectively scatter the light in the visible wavelength region.

The content of the first resin 16 with respect to the total mass of the fine particle-containing resin is preferably from 50 to 99% by mass, more preferably from 55 to 98% by mass, even more preferably from 60 to 97% by mass, and even more preferably from 65 to 95% by mass in a case in which the surface relief structure layer 11 is composed of a fine particle-containing resin. The light transmitting property of the optical film 10 is excellent and the light extraction efficiency of the surface light-emitting body is excellent when the content of the first resin 16 with respect to the total mass of the fine particle-containing resin is 50% by mass or more. In addition, it is possible to suppress the exiting angle dependency of the exited light wavelength in the surface light-emitting body when the content of the first resin 16 with respect to the total mass of the fine particle-containing resin is 99% by mass or less.

The content of the fine particles 15 with respect to the total mass of the fine particle-containing resin is preferably from 1 to 50% by mass, more preferably from 2 to 45% by mass, even more preferably from 3 to 40% by mass, and even more preferably from 5 to 35% by mass in a case in which the surface relief structure layer 11 is composed of a fine particle-containing resin. It is possible to suppress the exiting angle dependency of the exited light wavelength in the surface light-emitting body when the content of the fine particles 15 with respect to the total mass of the fine particle-containing resin is 1% by mass or more. In addition, the light transmitting property of the optical film 10 is excellent and the light extraction efficiency of the surface light-emitting body is excellent when the content of the fine particles 15 with respect to the total mass of the fine particle-containing resin is 50% by mass or less.

The light diffusing effect by the fine particles 15 is generated as there is a difference in refractive index between the first resin 16 and the fine particles 15. The difference in refractive index between the first resin 16 and the fine particles 15 is preferably from 0.01 to 0.20, more preferably from 0.03 to 0.17, and even more preferably from 0.05 to 0.15 from the viewpoint of an excellent light extraction efficiency or normal brightness of the surface light-emitting body.

Examples of the combination of the first resin 16 and the fine particles 15 may include a combination of an acrylic resin as the first resin 16 and silicon fine particles as the fine particles 15, a combination of an acrylic resin as the first resin 16 and aluminum fine particles as the fine particles 15, a combination of an acrylic resin as the first resin 16 and magnesium fine particles as the fine particles 15, a combination of an acrylic resin as the first resin 16 and silicon oxide fine particles as the fine particles 15, a combination of an acrylic resin as the first resin 16 and aluminum oxide fine particles as the fine particles 15, a combination of an acrylic resin as the first resin 16 and magnesium oxide fine particles as the fine particles 15, a combination of an acrylic resin as the first resin 16 and aluminum hydroxide fine particles as the fine particles 15, a combination of an acrylic resin as the first resin 16 and magnesium carbonate fine particles as the fine particles 15, a combination of an acrylic resin as the first resin 16 and acrylic resin fine particles as the fine particles 15, a combination of an acrylic resin as the first resin 16 and styrene resin fine particles as the fine particles 15, a combination of an acrylic resin as the first resin 16 and silicone resin fine particles as the fine particles 15, a combination of an acrylic resin as the first resin 16 and urethane resin fine particles as the fine particles 15, a combination of an acrylic resin as the first resin 16 and melamine resin fine particles as the fine particles 15, a combination of an acrylic resin as the first resin 16 and epoxy resin fine particles as the fine particles 15, a combination of a polycarbonate resin as the first resin 16 and silicon fine particles as the fine particles 15, a combination of a polycarbonate resin as the first resin 16 and aluminum fine particles as the fine particles 15, a combination of a polycarbonate resin as the first resin 16 and magnesium fine particles as the fine particles 15, a combination of a polycarbonate resin as the first resin 16 and silicon oxide fine particles as the fine particles 15, a combination of a polycarbonate resin as the first resin 16 and aluminum oxide fine particles as the fine particles 15, a combination of a polycarbonate resin as the first resin 16 and magnesium oxide fine particles as the fine particles 15, a combination of a polycarbonate resin as the first resin 16 and aluminum hydroxide fine particles as the fine particles 15, a combination of a polycarbonate resin as the first resin 16 and magnesium carbonate fine particles as the fine particles 15, a combination of a polycarbonate resin as the first resin 16 and acrylic resin fine particles as the fine particles 15, a combination of a polycarbonate resin as the first resin 16 and styrene resin fine particles as the fine particles 15, a combination of a polycarbonate resin as the first resin 16 and silicone resin fine particles as the fine particles 15, a combination of a polycarbonate resin as the first resin 16 and urethane resin fine particles as the fine particles 15, a combination of a polycarbonate resin as the first resin 16 and melamine resin fine particles as the fine particles 15, a combination of a polycarbonate resin as the first resin 16 and epoxy resin fine particles as the fine particles 15, a combination of polyethylene terephthalate as the first resin 16 and silicon fine particles as the fine particles 15, a combination of polyethylene terephthalate as the first resin 16 and aluminum fine particles as the fine particles 15, a combination of polyethylene terephthalate as the first resin 16 and magnesium fine particles as the fine particles 15, a combination of polyethylene terephthalate as the first resin 16 and silicon oxide fine particles as the fine particles 15, a combination of polyethylene terephthalate as the first resin 16 and aluminum oxide fine particles as the fine particles 15, a combination of polyethylene terephthalate as the first resin 16 and magnesium oxide fine particles as the fine particles 15, a combination of polyethylene terephthalate as the first resin 16 and aluminum hydroxide fine particles as the fine particles 15, a combination of polyethylene terephthalate as the first resin 16 and magnesium carbonate fine particles as the fine particles 15, a combination of polyethylene terephthalate as the first resin 16 and acrylic resin fine particles as the fine particles 15, a combination of polyethylene terephthalate as the first resin 16 and styrene resin fine particles as the fine particles 15, a combination of polyethylene terephthalate as the first resin 16 and silicone resin fine particles as the fine particles 15, a combination of polyethylene terephthalate as the first resin 16 and urethane resin fine particles as the fine particles 15, a combination of polyethylene terephthalate as the first resin 16 and melamine resin fine particles as the fine particles 15, and a combination of polyethylene terephthalate as the first resin 16 and epoxy resin fine particles as the fine particles 15. Among the combinations of the first resin 16 and the fine particles 15, a combination of an acrylic resin as the first resin 16 and silicon fine particles as the fine particles 15, a combination of an acrylic resin as the first resin 16 and aluminum fine particles as the fine particles 15, a combination of an acrylic resin as the first resin 16 and magnesium fine particles as the fine particles 15, a combination of an acrylic resin as the first resin 16 and silicon oxide fine particles as the fine particles 15, a combination of an acrylic resin as the first resin 16 and aluminum oxide fine particles as the fine particles 15, a combination of an acrylic resin as the first resin 16 and magnesium oxide fine particles as the fine particles 15, a combination of an acrylic resin as the first resin 16 and aluminum hydroxide fine particles as the fine particles 15, a combination of an acrylic resin as the first resin 16 and magnesium carbonate fine particles as the fine particles 15, a combination of an acrylic resin as the first resin 16 and acrylic resin fine particles as the fine particles 15, a combination of an acrylic resin as the first resin 16 and styrene resin fine particles as the fine particles 15, a combination of an acrylic resin as the first resin 16 and silicone resin fine particles as the fine particles 15, a combination of an acrylic resin as the first resin 16 and urethane resin fine particles as the fine particles 15, a combination of an acrylic resin as the first resin 16 and melamine resin fine particles as the fine particles 15, and a combination of an acrylic resin as the first resin 16 and epoxy resin fine particles as the fine particles 15 are preferable and a combination of an acrylic resin as the first resin 16 and silicon oxide fine particles as the fine particles 15, a combination of an acrylic resin as the first resin 16 and aluminum oxide fine particles as the fine particles 15, a combination of an acrylic resin as the first resin 16 and aluminum hydroxide fine particles as the fine particles 15, a combination of an acrylic resin as the first resin 16 and magnesium carbonate fine particles as the fine particles 15, a combination of an acrylic resin as the first resin 16 and acrylic resin fine particles as the fine particles 15, a combination of an acrylic resin as the first resin 16 and styrene resin fine particles as the fine particles 15, a combination of an acrylic resin as the first resin 16 and silicone resin fine particles as the fine particles 15, a combination of an acrylic resin as the first resin 16 and urethane resin fine particles as the fine particles 15, a combination of an acrylic resin as the first resin 16 and melamine resin fine particles as the fine particles 15, and a combination of an acrylic resin as the first resin 16 and epoxy resin fine particles as the fine particles 15 are more preferable from the viewpoint of excellent heat resistance, mechanical properties, and molding processability of the optical film 10, a preferred range of the difference in refractive index, and an excellent light extraction efficiency or normal brightness of the surface light-emitting body.

The surface relief structure layer 11 may contain other components in addition to the first resin 16 and the fine particles 15 in a range in which the performance is not impaired.

Examples of the other components may include various kinds of additives such as a mold releasing agent, a flame retardant, an antistatic agent, a leveling agent, an antifouling property improver, a dispersion stabilizer, and a viscosity modifier.

The content of the other components in the surface relief structure layer 11 is preferably 5% by mass or less, more preferably 3% by mass or less, and even more preferably 1% by mass or less with respect to the total mass of the materials constituting the surface relief structure layer 11. It is possible to suppress the deterioration in performance of the optical film 10 when the content of the other components in the surface relief structure layer 11 is 5% by mass or less with respect to the total mass of the materials constituting the surface relief structure layer 11.

A protective film may be provided on the surface having the relief structure 14 of the optical film 10 of the invention in order to protect the relief structure 14 and to improve the handling property of the optical film 10. The protective film may be peeled off from the optical film 10 when using the optical film 10.

Examples of the protective film may include a known protective film.

### (Diffraction grating layer 12)

The diffraction grating layer 12 has a diffraction grating.

The diffraction grating layer 12 is not particularly limited as long as it has a diffraction grating, and a commercially available diffraction film may be used as it is or one obtained by transferring a pattern of a commercially available diffraction film to a desired resin (second transparent resin) or the like may be used.

Examples of the commercially available diffraction film may include the "DTM-1-1", "DTM-1-2", "DTM-1-3", "DTM-2-1", "DTM -2-2", "DTM-2-3", "DTM-3-1", and "DTM-3-2" manufactured by KYODO INTERNATIONAL,INC.; and the "FALS1000/1000-30×30", "FTH500/500-50×50", and "FAP250/500-30x30" manufactured by SCIVAX Corporation.

Examples of the pattern of the diffraction grating of the diffraction grating layer 12 may include a continuous pattern such as a one-dimensional pattern including a line-and-space; and a two-dimensional pattern including a pillar pattern, a hole pattern, a check pattern, a curve pattern, or a grid pattern. Among these patterns of the diffraction grating of the diffraction grating layer 12, a two-dimensional pattern such as a pillar pattern, a hole pattern, a check pattern, a curve pattern, or a grid pattern is preferable and a pillar pattern or a hole pattern is more preferable from the viewpoint of an excellent light extraction efficiency or normal brightness of the surface light-emitting body.

Examples of the shape of the diffraction grating having a pillar pattern or a hole pattern may include a prismatic shape such as a triangular prism shape or a quadrangular prism shape; and a columnar shape.

The pitch of the diffraction grating of the diffraction grating layer 12 is preferably from 0.2 to 5 µm, and more preferably from 0.5 to 4 µm from the viewpoint of an excellent light extraction efficiency or normal brightness of the surface light-emitting body.

The pitch of the diffraction grating represents the dimensions of one period where one convex structure and one concave structure adjacent to this of the diffraction grating pattern are adopted as one period.

The depth (height) of the diffraction grating of the diffraction grating layer 12 is preferably from 0.2 to 5 µm, and more preferably from 0.5 to 4 µm from the viewpoint of an excellent light extraction efficiency or normal brightness of the surface light-emitting body.

The height of the diffraction grating represents the dimensions from the top of the diffraction grating pattern to the bottom of the diffraction grating pattern.

Examples of the material of the diffraction grating layer 12 may include an acrylic resin; a polycarbonate resin; a polyester resin such as polyethylene terephthalate, polybutylene terephthalate, or polyethylene naphthalate; a styrene resin such as polystyrene or an ABS resin; a vinyl chloride resin; a cellulose resin such as diacetyl cellulose or triacetyl cellulose; an imide resin such as polyimide or polyamide-imide; and glass.

The refractive index of the diffraction grating layer 12 is preferably from 1.30 to 1.80, more preferably from 1.35 to 1.75, and even more preferably from 1.40 to 1.70 from the viewpoint of an excellent light extraction efficiency or normal brightness of the surface light-emitting body.

The diffraction effect by the diffraction grating layer 12 is generated as there is a difference in refractive index between the surface relief structure layer 11 and the diffraction grating layer 12. The difference in refractive index between the first transparent material of the surface relief structure layer 11 and the second transparent material of the diffraction grating layer 12 is preferably from 0.01 to 0.30, more preferably from 0.03 to 0.25, and even more preferably from 0.05 to 0.20 from the viewpoint of an excellent light extraction efficiency or normal brightness of the surface light-emitting body.

### (Intermediate layer 13)

The intermediate layer 13 may be provided between the surface relief structure layer 11 and the diffraction grating layer 12 in order to support the relief structure 14 of the surface relief structure layer 11 and to fill the gap generated by the diffraction grating of the diffraction grating layer 12. Incidentally, it looks like that the intermediate layer 12 in FIG. 1 indicates only the part between the surface relief structure layer 11 and the diffraction grating layer 12 for convenience, but the intermediate layer 12 also includes the interspace part between the diffraction grating patterns of the diffraction grating layer 12 as described above.

The material of the intermediate layer 13 preferably has the same composition as the surface relief structure layer 11 from the viewpoint of excellent productivity of the optical film 10.

### (Substrate 18)

The substrate 18 may be provided on the surface that does not have the relief structure 14 of the optical film 10 of the invention in order to maintain the shape of the optical film 10. In other words, the substrate 18 may be provided on the surface on the side opposite to the surface having the relief structure 14 of the optical film 10.

As the substrate 18, a substrate that transmits an active energy ray is preferable from the viewpoint of excellent curability of the active energy ray-curable composition. Moreover, it is preferable that the substrate 18 transmits visible light in order to allow light to reach the surface relief structure layer 11. Specifically, it is preferable that the transmittance of visible light passing through the substrate 18 with respect to visible light incident on the substrate 18 is 50% or more. Incidentally, the light transmittance is a value measured in conformity with JIS K7361.

Examples of the material of the substrate 18 may include an acrylic resin; a polycarbonate resin; a polyester resin such as polyethylene terephthalate, polybutylene terephthalate, or polyethylene naphthalate; a styrene resin such as polystyrene or an ABS resin; a vinyl chloride resin; a cellulose resin such as diacetyl cellulose or triacetyl cellulose; an imide resin such as polyimide or polyamide-imide; and glass. Among these materials of the substrate 18, an acrylic resin, a polycarbonate resin, a polyester resin, a styrene resin, a cellulose resin, and an imide resin are preferable and an acrylic resin, a polycarbonate resin, a polyester resin, and an imide resin are more preferable from the viewpoint of excellent flexibility and excellent active energy ray transmitting property.

The thickness of the substrate 18 is preferably from 10 to 1,000 µm, more preferably from 20 to 500 µm, and even more preferably from 25 to 300 µm from the viewpoint of excellent curability of the active energy ray-curable composition.

The substrate 18 may be subjected to the adhesion promoting treatment of the surface of the substrate 18 in order to improve the adhesive property between the diffraction grating layer 12 and the substrate 18 if necessary.

Examples of the method for the adhesion promoting treatment may include a method to form an adhesion promoting layer composed of a polyester resin, an acrylic resin, and a urethane resin on the surface of the substrate 18 and a method to subject the surface of the substrate 18 to the surface roughening treatment.

The substrate 18 may be subjected to the surface treatment for the prevention of static charge, the prevention of reflection, and the prevention of adhesion between the substrates in addition to the adhesion promoting treatment if necessary.

A pressure sensitive adhesive layer 21 may be provided on the surface that does not have the relief structure 14 of the optical film 10 of the invention in order to allow the optical film 10 to adhere to the EL light-emitting device 30. In other words, the pressure sensitive adhesive layer 21 may be provided on the surface on the side opposite to the surface having the relief structure 14 of the optical film 10. The pressure sensitive adhesive layer 21 may be provided on the surface of the substrate 18 as illustrated in Fig. 1 in a case in which the optical film 10 includes the substrate 18.

In other words, the optical film of the invention may have a configuration which includes an optical film including a substrate, a surface relief structure layer that is positioned on the substrate, is composed of a first transparent material, and has a relief structure, and a diffraction grating layer that is positioned between the substrate and the surface relief structure layer and composed of a second transparent material, and the pressure sensitive adhesive layer 21 provided on the surface opposite to the surface on which the surface relief structure layer is positioned of the substrate.

Examples of the pressure sensitive adhesive layer 21 may include a known pressure sensitive adhesive.

The protective film 22 may be provided on the surface of the pressure sensitive adhesive layer 21 in order to enhance the handling property of the optical film 10 as illustrated in Fig. 1.

In other words, the optical film of the invention may have a configuration which includes an optical film including a substrate, a surface relief structure layer that is positioned on the substrate, is composed of a first transparent material, and has a relief structure, and a diffraction grating layer that is positioned between the substrate and the surface relief structure layer and composed of a second transparent material, the pressure sensitive adhesive layer 21 provided on the surface opposite to the surface on which the surface relief structure layer is positioned of the substrate, and the protective film positioned on the pressure sensitive adhesive layer 21.

The protective film 22 may be peeled off from the optical film 10 or the like when bonding the optical film 10 or the like on the surface of the EL light-emitting device 30.

Examples of the protective film 22 may include a known protective film.

### (Method for manufacturing optical film 10)

The method for manufacturing the optical film 10 of the invention is not particularly limited, but examples thereof may include a method in which a second active energy ray-curable composition is coated on the substrate 18, a die having the transfer portion of the diffraction grating is covered thereon, and the resultant is irradiated with a second active energy ray to obtain a film having the diffraction grating layer 12 on the substrate 18, and a first active energy ray-curable composition is coated on the film having the diffraction grating layer 12 on the substrate 18 thus obtained, a die having the transfer portion of the relief structure 14 is covered thereon, and the resultant is irradiated with a first active energy ray.

In addition, a method is exemplified in which a second active energy ray-curable composition is supplied to between a substrate and a die having the transfer portion of a diffraction grating and irradiated with a second active energy ray to obtain a stacked body having a diffraction grating layer on the substrate, and a first active energy ray-curable composition is supplied to between the stacked body thus obtained and a die having the transfer portion of a relief structure and irradiated with a first active energy ray.

As the second active energy ray-curable composition, it is possible to use the same material as the first active energy ray-curable composition. However, as described above, a material which allows the refractive index of the diffraction grating layer 12 to be in the above preferred range is selected as the second active energy ray-curable composition.

The die having the transfer portion of the diffraction grating or the die having the transfer portion of the relief structure 14 is not be particularly limited as long as it has the desired transfer surface, a commercially available die may be used as it is or one manufactured by a known method such as cutting by a diamond byte or etching as described in WO 2008/069324 A.

Specifically, the die having the transfer portion of the diffraction grating has a shape obtained by inverting the pattern of the diffraction grating of the diffraction grating layer 12 described above. In addition, the die having the transfer portion of the relief structure 14 has a shape obtained by inverting the shape of the relief structure 14.

Examples of the light-emitting source of the first and second active energy rays may include a chemical lamp, a low pressure mercury lamp, a high pressure mercury lamp, a metal halide lamp, an electrodeless ultraviolet lamp, a visible light halogen lamp, and a xenon lamp. The integrated light quantity of the first and second active energy rays may be appropriately set depending on the kinds of the first and second active energy ray-curable compositions to be used, but it is preferably from 0.01 to 10 J/cm² and more preferably from 0.5 to 8 J/cm² from the viewpoint of excellent curability of the first and second active energy ray-curable compositions and the suppression of deterioration of the optical film 10.

The optical film 10 described above can be provided on the light-exiting side of the surface light-emitting body to be described later. Specifically, the optical film 10 can be provided on the light-exiting side of an EL light-emitting device so as to be utilized as a flat panel display or as a luminaire.

### (Surface light-emitting body)

The surface light-emitting body of the invention includes the optical film 10 of the invention.

Examples of the surface light-emitting body of the invention may include a surface light-emitting body as illustrated in Fig. 5.

Hereinafter, the surface light-emitting body of the invention illustrated in Fig. 5 will be described, but the surface light-emitting body of the invention is not limited to the surface light-emitting body illustrated in Fig. 5.

The surface light-emitting body illustrated in Fig. 5 includes an EL light-emitting device 30 fabricated by sequentially stacking a glass substrate 31, an anode 32, a light-emitting layer 33, and a cathode 34, the pressure sensitive adhesive layer 21, and the optical film 10. The optical film 10 is provided on the surface on the side opposite to the surface on which the EL light-emitting device 30 is formed of the glass substrate 31 via the pressure sensitive adhesive layer 21.

The surface light-emitting body fabricated by providing the optical film 10 of the invention to the EL light-emitting device 30 achieves both an improvement in light extraction efficiency or normal brightness and the suppression of exiting angle dependency of the exited light wavelength.

Incidentally, the optical film of the present embodiment may include a surface relief structure layer that is composed of a first transparent material and has a relief structure and a diffraction grating layer composed of a second transparent material, in which the first transparent material may be an acrylic resin and the diffraction grating pattern of the diffraction grating layer may be a pillar pattern.

The optical film of the present embodiment may include a surface relief structure layer that is composed of a first transparent material and has a relief structure and a diffraction grating layer composed of a second transparent material, in which the first transparent material may be an acrylic resin, the diffraction grating pattern of the diffraction grating layer may be a pillar pattern, and a difference in refractive index between the first transparent material and the second transparent material may be from 0.03 to 0.17.

The optical film of the present embodiment may include a surface relief structure layer that is composed of a first transparent material and has a relief structure and a diffraction grating layer composed of a second transparent material, in which the first transparent material may be an acrylic resin and the diffraction grating pattern of the diffraction grating layer may be a grid pattern.

The optical film of the present embodiment may include a surface relief structure layer that is composed of a first transparent material and has a relief structure and a diffraction grating layer composed of a second transparent material, in which the first transparent material may be an acrylic resin, the diffraction grating pattern of the diffraction grating layer may be a grid pattern, and a difference in refractive index between the first transparent material and the second transparent material may be from 0.03 to 0.17.

The optical film of the present embodiment may include a surface relief structure layer that is composed of a first transparent material and light-diffusing fine particles and has a relief structure and a diffraction grating layer composed of a second transparent material, in which the first transparent material may be an acrylic resin, the light-diffusing fine particles may be a silicone resin, and the diffraction grating pattern of the diffraction grating layer may be a pillar pattern.

The optical film of the present embodiment may include a surface relief structure layer that is composed of a first transparent material and light-diffusing fine particles and has a relief structure and a diffraction grating layer composed of a second transparent material, in which the first transparent material may be an acrylic resin, the light-diffusing fine particles may be a silicone resin, the light-diffusing fine particles may be spherical, and the diffraction grating pattern of the diffraction grating layer may be a pillar pattern.

The optical film of the present embodiment may include a surface relief structure layer that is composed of a first transparent material and light-diffusing fine particles and has a relief structure and a diffraction grating layer composed of a second transparent material, in which the first transparent material may be an acrylic resin, the light-diffusing fine particles may be a silicone resin, the light-diffusing fine particles with respect to the total mass of the materials forming the surface relief structure layer may be from 5 to 35%, and the diffraction grating pattern of the diffraction grating layer may be a pillar pattern.

The optical film of the present embodiment may include a surface relief structure layer that is composed of a first transparent material and light-diffusing fine particles and has a relief structure and a diffraction grating layer composed of a second transparent material, in which the first transparent material may be an acrylic resin, the light-diffusing fine particles may be a silicone resin, a difference in refractive index between the first transparent material and the light-diffusing fine particles may be from 0.05 to 0.15, and the diffraction grating pattern of the diffraction grating layer may be a pillar pattern.

The optical film of the present embodiment may include a surface relief structure layer that is composed of a first transparent material and light-diffusing fine particles and has a relief structure and a diffraction grating layer composed of a second transparent material, in which the first transparent material may be an acrylic resin, the light-diffusing fine particles may be a silicone resin, and the diffraction grating pattern of the diffraction grating layer may be a grid pattern.

The optical film of the present embodiment may include a surface relief structure layer that is composed of a first transparent material and light-diffusing fine particles and has a relief structure and a diffraction grating layer composed of a second transparent material, in which the first transparent material may be an acrylic resin, the light-diffusing fine particles may be a silicone resin, the light-diffusing fine particles may be spherical, and the diffraction grating pattern of the diffraction grating layer may be a grid pattern.

The optical film of the present embodiment may include a surface relief structure layer that is composed of a first transparent material and light-diffusing fine particles and has a relief structure and a diffraction grating layer composed of a second transparent material, in which the first transparent material may be an acrylic resin, the light-diffusing fine particles may be a silicone resin, the light-diffusing fine particles with respect to the total mass of the materials forming the surface relief structure layer may be from 5 to 35%, and the diffraction grating pattern of the diffraction grating layer may be a grid pattern.

The optical film of the present embodiment may include a surface relief structure layer that is composed of a first transparent material and light-diffusing fine particles and has a relief structure and a diffraction grating layer composed of a second transparent material, in which the first transparent material may be an acrylic resin, the light-diffusing fine particles may be a silicone resin, a difference in refractive index between the first transparent material and the light-diffusing fine particles may be from 0.05 to 0.15, and the diffraction grating pattern of the diffraction grating layer may be a grid pattern.

### EXAMPLES

Hereinafter, the invention will be specifically described with reference to Examples, but the invention is not limited to these Examples.

Incidentally, the "parts" and "%" in Examples indicate the "parts by mass" and "% by mass", respectively.

### (Observation of cross section of optical film)

The surface having a relief structure or cross section of the optical films obtained in Examples were observed using an electron microscope (model name "S-4300-SE/N" manufactured by Hitachi High-Technologies Corporation).

Incidentally, the cross section of the optical film was observed by cutting the optical films obtained in Example 1 and Example 4 through the vertex of the relief structure and to be perpendicular to the bottom surface portion of the relief structure using a razor blade.

### (Measurement of light extraction efficiency)

A light shielding sheet which had a hole with a diameter of 5 mm and a thickness of 0.1 mm was disposed on the surface light-emitting bodies obtained in Examples, Comparative Examples, and Reference Examples, and this was disposed on the sample opening of an integrating sphere (manufactured by Labsphere, Inc., size: 6 inches). In this state, the light exiting through the hole with a diameter of 5 mm of the light shielding sheet when the integrating sphere was lit by applying a current of 10 mA to the organic EL light-emitting device was measured using a spectroscopic measuring instrument (spectrometer: model name "PMA-12" (manufactured by Hamamatsu Photonics K.K.), software: software name "basic software U6039-01 ver.3.3.1 for PMA"), the correction was conducted by the standard luminosity curve, and the number of photons of the surface light-emitting body was calculated.

The proportion of the number of photons of the surface light-emitting body obtained in Examples and Comparative Examples with respect to 100% of the number of photons of the surface-emitting bodies obtained in Reference Examples was adopted as the light extraction efficiency.

### (Measurement of normal brightness)

A light shielding sheet which had a hole with a diameter of 5 mm and a thickness of 0.1 mm was disposed on the surface light-emitting bodies obtained in Examples, Comparative Examples, and Reference Examples. In this state, the light exiting through the hole with a diameter of 5 mm of the light shielding sheet when the integrating sphere was lit by applying a current of 1.5 A to the organic EL light-emitting device was measured in the normal direction of the surface light-emitting body using a luminance meter (model name "BM-7" manufactured by Topcon Corporation) to obtain the brightness value of the surface light-emitting body.

The proportion of the brightness value of the surface light-emitting bodies obtained in Examples and Comparative Examples with respect to 100% of the brightness value of the surface-emitting bodies obtained in Reference Examples was adopted as the normal brightness.

### (Measurement of quantity of change in chromaticity)

A light shielding sheet which had a hole with a diameter of 5 mm and a thickness of 0.1 mm was disposed on the surface light-emitting bodies obtained in Examples, Comparative Examples, and Reference Examples. In this state, the light exiting through the hole with a diameter of 5 mm of the light shielding sheet when the integrating sphere was lit by applying a current of 1.5 A to the organic EL light-emitting device was measured using a luminance meter (model name "BM-7" manufactured by Topcon Corporation) to determine the chromaticity x and y of the xy color space in each of the normal direction (0°) of the surface light-emitting body, the direction inclining by 10° with respect to the normal direction of the surface light-emitting body, the direction inclining by 20° with respect to the normal direction of the surface light-emitting body, the direction inclining by 30° with respect to the normal direction of the surface light-emitting body, the direction inclining by 40° with respect to the normal direction of the surface light-emitting body, the direction inclining by 50° with respect to the normal direction of the surface light-emitting body, the direction inclining by 60° with respect to the normal direction of the surface light-emitting body, the direction inclining by 70° with respect to the normal direction of the surface light-emitting body, the direction inclining by 75° with respect to the normal direction of the surface light-emitting body, and the direction inclining by 80° with respect to the normal direction of the surface light-emitting body. The x values at the respective angles and the average x value were plotted on the horizontal axis, the y values at the respective angles and the average y value were plotted on the vertical axis, the distances from the points denoting the average x value and the average y value to the points denoting the x values at the respective angles and the y values at the respective angles were calculated, respectively, and the value at which the distance is the longest was adopted as the quantity of change in chromaticity.

Incidentally, it means that the exiting angle dependency of the exited light wavelength in the surface light-emitting body is more suppressed as the quantity of change in chromaticity is smaller.

### (Materials)

Active energy ray-curable composition A: active energy ray-curable composition prepared in Preparation Example 1 to be described later (refractive index of cured product: 1.52)
Active energy ray-curable composition B: active energy ray-curable composition prepared in Preparation Example 2 to be described later (refractive index of cured product: 1.58)
Active energy ray-curable composition C: active energy ray-curable composition prepared in Preparation Example 3 to be described later (refractive index of cured product: 1.52)
Active energy ray-curable composition D: active energy ray-curable composition prepared in Preparation Example 4 to be described later (refractive index of cured product: 1.52)
Active energy ray-curable composition E: active energy ray-curable composition prepared in Preparation Example 5 to be described later (refractive index of cured product: 1.52)
Fine particles A: silicone resin spherical fine particles (trade name: "Tospearl 120" manufactured by Momentive Performance Materials, Inc., refractive index: 1.42, volume average particle size: 2 µm)
Organic EL light-emitting device A: organic EL light-emitting device prepared by peeling off the optical film on the surface of the light-exiting surface side of the Symfos OLED-010K (manufactured by Konica Minolta, Inc., white OLED device) and
Organic EL light-emitting device B: organic EL light-emitting device prepared by peeling off the optical film on the surface of the light-exiting surface side of the OLED_Panel NZIP0S0808300 (manufactured by Panasonic Corporation, white OLED device)

### [Reference Example 1]

The organic EL light-emitting device A was used as the surface light-emitting body as it was.

### [Reference Example 2]

The organic EL light-emitting device B was used as the surface light-emitting body as it was.

### [Preparation Example 1]

### (Preparation of active energy ray-curable composition A)

Into a glass flask, 117.6 g (0.7 mol) of hexamethylene diisocyanate and 151.2 g (0.3 mol) of an isocyanurate type hexamethylene diisocyanate trimer as the diisocyanate compound, 128.7 g (0.99 mol) of 2-hydroxypropyl acrylate and 693 g (1.54 mol) of pentaerythritol triacrylate as the hydroxyl group-containing (meth)acrylate, 22.1 g of din-butyltin dilaurate as the catalyst, and 0.55 g of hydroquinone monomethyl ether as the polymerization inhibitor were introduced, and the temperature thereof was raised to 75°C, and the mixture was continuously stirred while maintaining at 75°C to react until the concentration of residual isocyanate compound in the flask reached 0.1 mol/L or less and then cooled to room temperature, thereby obtaining a urethane polyfunctional acrylate.

The active energy ray-curable resin composition A was obtained by mixing 35 parts of the urethane polyfunctional acrylate thus obtained, 20 parts of a dimethacrylate represented by the following Formula (1) (trade name "ACRYESTER PBOM" manufactured by Mitsubishi Rayon Co., Ltd.), 40 parts of a dimethacrylate represented by the following Formula (2) (trade name "NEW FRONTIER BPEM-10" manufactured by DKS Co., Ltd.), 5 parts of an acrylate represented by the following formula (3) (trade name "NEW FRONTIER PHE" manufactured by DKS Co., Ltd.), and 1.2 parts of 1-hydroxycyclohexyl phenyl ketone (trade name "Irgacure 184" manufactured by BASF) together.

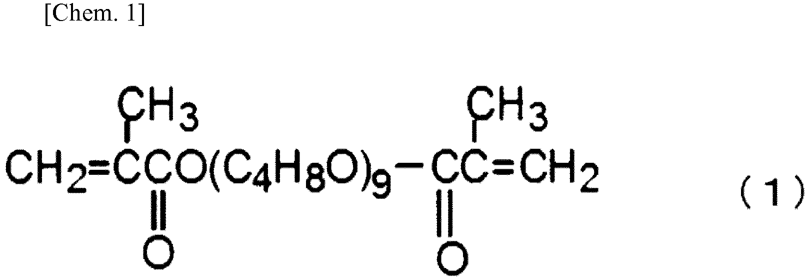

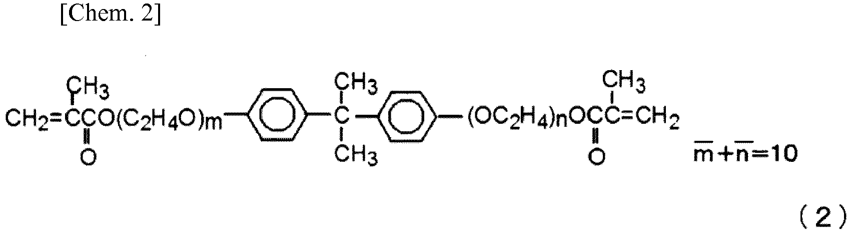

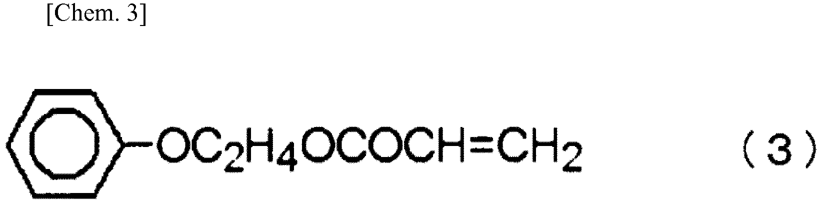

### [Preparation Example 2]

### (Preparation of active energy ray-curable composition B)

The active energy ray-curable resin composition B was obtained by mixing 100 parts of a urethane polyfunctional acrylate (trade name "GX8830A" manufactured by DKS Co., Ltd.) and 1.2 parts of 1-hydroxycyclohexyl phenyl ketone (trade name "Irgacure 184" manufactured by BASF).

### [Preparation Example 3]

### (Preparation of active energy ray-curable composition C)

The active energy ray-curable composition C was obtained by mixing the active energy ray-curable composition A and the fine particles A at 70% and 30%, respectively.

### [Preparation Example 4]

### (Preparation of active energy ray-curable composition D)

The active energy ray-curable composition D was obtained by mixing the active energy ray-curable composition A and the fine particles A at 90% and 10%, respectively.

### [Preparation Example 5]

### (Preparation of active energy ray-curable composition E)

The active energy ray-curable composition E was obtained by mixing the active energy ray-curable composition A and the fine particles A at 80% and 20%, respectively.

### [Preparation Example 6]

### (Preparation of flat die having transfer portion of relief structure)

A steel flat die of 100 mm² was plated with copper to form a plated layer having a thickness of 200 µm and the Vickers hardness of 200 Hv. A photosensitive agent was coated on the surface of the copper plated layer, and the resultant was exposed to a laser beam, developed, and etched, thereby obtaining a die having a transfer portion in which a hemispherical recess having a diameter of 50 µm and a depth of 25 µm were lined on the copper plated layer in a hexagonal arrangement at a minimum interval of 3 µm formed. The surface of the die thus obtained was plated with chromium in order to impart corrosion resistance and durability, thereby obtaining a flat die having the transfer portion of a relief structure.

### [Preparation Example 7]

### (Preparation of metal die having diffraction grating)

A steel flat die was subjected to an electroless nickel plating treatment and the mirror-finishing using a precision cutting machine. Subsequently, the mirror-finished surface was subjected to cutting using a single crystal diamond bite such that the linear grooves (pitch: 2 µm, depth: 0.4 µm) are formed to meet at right angles, thereby preparing a metal die having a diffraction grating.

### [Example 1]

The active energy ray-curable composition B was coated on a diffraction film with a hole pattern (trade name "DTM-2-1", pitch: 1 µm, depth: 1 µm), a polyethylene terephthalate substrate (trade name "DIAFOIL T910E125" manufactured by Mitsubishi Plastics, Inc.) having a thickness of 125 µm was placed thereon, and the resultant was uniformly stretched using the nip roll so that the diffraction grating layer had a thickness of 10 µm. Thereafter, the active energy ray-curable composition B sandwiched between the diffraction film and the substrate was cured by irradiating with ultraviolet light from above the substrate, and the cured product of the active energy ray-curable composition B was peeled off from the diffraction film, thereby obtaining a film having a diffraction grating layer having a diffraction grating with a pillar pattern formed on the substrate.

Thereafter, the active energy ray-curable composition C was coated on the flat die having the transfer portion of a relief structure obtained in Preparation Example 6, the film having a diffraction grating layer formed on a substrate thus obtained was placed thereon such that the surface having a diffraction grating faced down, and the resultant was uniformly stretched using the nip roll so that the intermediate layer had a thickness of 30 µm. Thereafter, the active energy ray-curable composition C sandwiched between the diffraction film and the substrate was cured by irradiating with ultraviolet light from above the substrate, and the cured product of the active energy ray-curable composition C was peeled off from the flat die having the transfer portion of a relief structure, thereby obtaining an optical film.

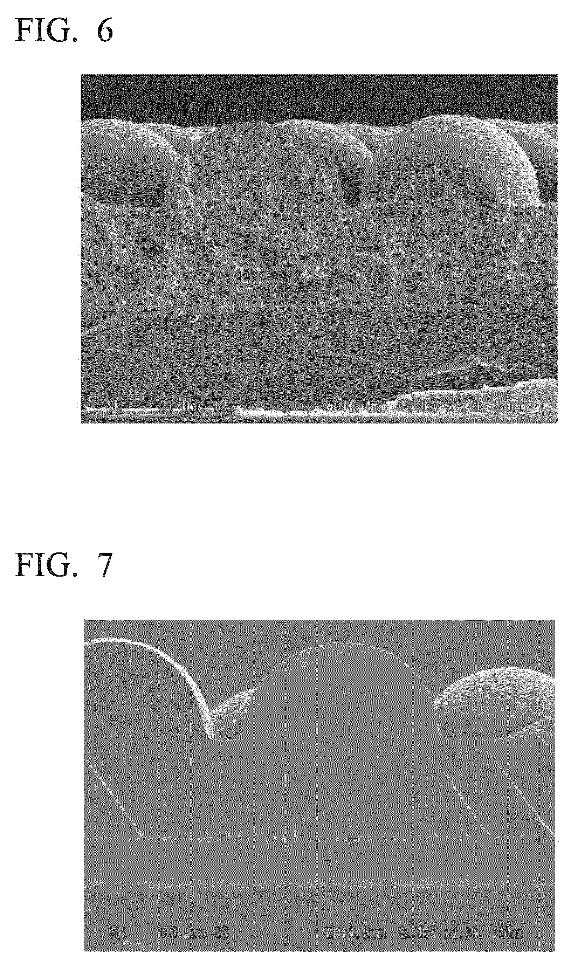

The image of the optical film thus obtained taken using a scanning microscope is illustrated in Fig. 6. As the size of the relief structure of the optical film calculated from the image taken using a scanning microscope, the average longest diameter, Aₐᵥₑ, was 48 µm and the average height, Bₐᵥₑ, was 24 µm, and a hemispherical protrusion that almost corresponded to the size of the recess of the roll die was obtained. In addition, from the image taken using a scanning microscope, it was confirmed that the relief structure of the optical film thus obtained was lined in a hexagonal arrangement at a minimum interval of 5.5 µm to correspond to the roll die and the proportion of the area of the bottom surface portion of the spherical protrusion with respect to the area of the optical film was 73%.

The Cargill standard refractive liquid (manufactured by MORITEX Corporation, refractive index: 1.52) as a pressure sensitive adhesive layer was coated on the light exiting surface side of the organic EL light-emitting device A, and the surface of the substrate of the optical film having the substrate thus obtained was allowed to optically adhere thereto, thereby obtaining a surface light-emitting body. The light extraction efficiency, normal brightness, and quantity of change in chromaticity of the surface light-emitting body thus obtained are presented in Table 1.

### [Examples 2 and 3]

The surface light-emitting bodies were obtained by conducting an operation in the same manner as in Example 1 except that the kind of the active energy ray-curable composition or the pitch of the diffraction grating was changed. The light extraction efficiency, normal brightness, and quantity of change in chromaticity of the surface light-emitting bodies thus obtained are presented in Table 1.

### [Comparative Example 1]

The active energy ray-curable composition C was coated on the flat die having the transfer portion of a relief structure obtained in Preparation Example 6, a polyethylene terephthalate substrate (trade name "DIAFOIL T910E125" manufactured by Mitsubishi Plastics, Inc.) having a thickness of 125 µm was placed thereon, and the resultant was uniformly stretched using the nip roll so that the intermediate layer had a thickness of 30 µm. Thereafter, the active energy ray-curable composition C sandwiched between the diffraction film and the substrate was cured by irradiating with ultraviolet light from above the substrate, and the cured product of the active energy ray-curable composition C was peeled off from the flat die having the transfer portion of a relief structure, thereby obtaining an optical film.

The surface light-emitting body was obtained by conducting an operation in the same manner as in Example 1 except the above. The light extraction efficiency, normal brightness, and quantity of change in chromaticity of the surface light-emitting body thus obtained are presented in Table 1.

**[Table 1]**

| | Relief structure layer | | | | Diffraction grating layer | | | | | Kind of organc EL light-emitting element | Surface light-emitting body | | |
|---|---|---|---|---|---|---|---|---|---|---|---|---|---|
| | Kind of composition | Content of fine particles (%) | Refractive index of resin | Refractive index of fine particles | Kind of composition | Shape of diffraction grating | Pitch of diffraction grating (mm) | Depth of diffraction grafting (µm) | Refractive index of resin | | Light extraction efficiency (%) | Normal brightness (%) | Quantity of change in chromaticity |
| Reference Example 1 | - | - | - | - | - | - | - | - | - | A | 100 | 100 | 0.024 |
| Example 1 | C | 30 | 1.52 | 1.42 | B | Pillar pattern | 1 | 1 | 1.58 | A | 197.6 | 197.6 | 0.0016 |
| Example 2 | C | 30 | 1.52 | 1.42 | B | Pillar pattern | 2 | 1 | 1.58 | A | 190.5 | 207.6 | 0.0011 |
| Example 3 | C | 30 | 1.52 | 1.42 | B | Pillar pattern | 4 | 1 | 1.58 | A | 198.7 | 195.5 | 0.0023 |
| Comparative Example 1 | C | 30 | 1.52 | 1.42 | - | - | - | - | - | A | 179.4 | 190.3 | 0.0057 |

In the surface light-emitting bodies that included the optical film of the invention and were obtained in Examples 1 to 3, it was possible to improve the light extraction efficiency or normal brightness and to suppress the exiting angle dependency of the exited light wavelength.

On the other hand, the surface light-emitting body that included an optical film not including a diffraction grating layer and was obtained in Comparative Example 1 had a poor light extraction efficiency or exhibited poor exiting angle dependency of the exited light wavelength.

### [Examples 4 to 6]

The surface light-emitting bodies were obtained by conducting an operation in the same manner as in Example 1 except that the kind of the active energy ray-curable composition or the pitch of the diffraction grating was changed. The light extraction efficiency, normal brightness, and quantity of change in chromaticity of the surface light-emitting bodies thus obtained are presented in Table 2.

### [Example 7]

The active energy ray-curable composition B was coated on the metal die that had a diffraction grating with a grid pattern (pitch: 2 µm, depth: 0.4 µm) and was obtained in Preparation Example 7, a polyethylene terephthalate substrate (trade name "DIAFOIL T910E125" manufactured by Mitsubishi Plastics, Inc.) having a thickness of 125 µm was placed thereon, and the resultant was uniformly stretched using the nip roll so that the diffraction grating layer had a thickness of 10 µm. Thereafter, the active energy ray-curable composition B sandwiched between the diffraction film and the substrate was cured by irradiating with ultraviolet light from above the substrate, and the cured product of the active energy ray-curable composition B was peeled off from the metal die having a diffraction grating, thereby obtaining a film having a diffraction grating layer having a diffraction grating with a grid pattern formed on a substrate.

Thereafter, an operation was conducted in the same manner as in Example 1, thereby obtaining a surface light-emitting body. The light extraction efficiency, normal brightness, and quantity of change in chromaticity of the surface light-emitting body thus obtained are presented in Table 2.

### [Examples 8 to 12]

The surface light-emitting bodies were obtained by conducting an operation in the same manner as in Example 7 except that the kind of the active energy ray-curable composition or the depth of the diffraction grating was changed. The light extraction efficiency, normal brightness, and quantity of change in chromaticity of the surface light-emitting bodies thus obtained are presented in Table 2.

Incidentally, a metal die having a diffraction grating with a different depth was prepared in the same manner as in Preparation Example 7.

**[Table 2]**

| | Relief structure layer | | | | Diffraction grating layer | | | | | Kind of organic EL light-emitting element | Surface light-emitting bodv | | |
|---|---|---|---|---|---|---|---|---|---|---|---|---|---|
| | Kind of composition | Content of fine particles (%) | Refractive index of resin | Refractive index of fine particles | Kind of composition | Shape of diffraction grating | Pitch of diffraction grating (mm) | Depth of diffraction grating (mm) | Refractive index of resin | | Light extraction efficiency (%) | Normal brightness (%) | Quantity of change in chromaticity |
| Reference Example 1 | - | - | - | - | - | - | - | | - | A | 100 | 100 | 0.024 |
| Example 4 | A | - | 1.52 | - | B | Pillar pattern | 1 | 1 | 1.58 | A | 214.3 | 167.7 | 0.0014 |
| Example 5 | A | - | 1.52 | - | B | Pillar pattern | 2 | 1 | 1.58 | A | 215 | 162.3 | 0.0015 |
| Example 6 | A | - | 1.52 | - | B | Pillar pattern | 4 | 1 | 1.58 | A | 209.8 | 163.6 | 0.0014 |
| Example 7 | C | 30 | 1.52 | 1.42 | B | Pillar pattern | 2 | 0.4 | 1.58 | A | 172.6 | 169.7 | 0.0017 |
| Example 8 | C | 30 | 1.52 | 1.42 | B | Pillar pattern | 2 | 0.8 | 1.58 | A | 170.5 | 169.9 | 0.0022 |
| Example 9 | C | 30 | 1.52 | 1.42 | B | Pillar pattern | 2 | 1.2 | 1.58 | A | 172.3 | 166.1 | 0.0028 |
| Example 10 | A | - | 1.52 | - | B | Pillar pattern | 2 | 0.4 | 1.58 | A | 180.8 | 158.8 | 0.0116 |
| Example 11 | A | - | 1.52 | - | B | Pillar pattern | 2 | 0.8 | 1.58 | A | 181.3 | 159 | 0.0121 |
| Example 12 | A | - | 1.52 | - | B | Pillar pattern | 2 | 1.2 | 1.58 | A | 180 | 159.2 | 0.0107 |

### [Examples 13 to 24]

The surface light-emitting bodies were obtained by conducting an operation in the same manner as in Example 1 except that the kind of the organic EL light-emitting device, the kind of the active energy ray-curable composition, and the pitch or depth of the diffraction grating were changed. The light extraction efficiency, normal brightness, and quantity of change in chromaticity of the surface light-emitting bodies thus obtained are presented in Table 3.

**[Table 3]**

| | Relief structure layer | | | | Diffraction grating layer | | | | | Kind of organic EL light-emitting element | Surface light-emitting body | | |
|---|---|---|---|---|---|---|---|---|---|---|---|---|---|
| | Kind of composition | Content of fine particles (%) | Refractive index of resin | Refractive index of fine particles | Kind of composition | Shape of diffraction grating | Pitch of diffraction grating (mm) | Depth of diffraction grating (mm) | Refractive index of resin | | Light extraction efficiency (%) | Normal brightness (%) | Quantity of change in chromaticity |
| Reference Example 2 | - | - | - | - | - | - | - | | - | B | 100 | 100 | 0.0159 |
| Example 13 | C | 30 | 1.52 | 1.42 | B | Pillar pattern | 1 | 1 | 1.58 | B | 151.7 | 140.4 | 0.0023 |
| Example 14 | C | 30 | 1.52 | 1.42 | B | Pillar pattern | 2 | 1 | 1.58 | B | 156.5 | 144.7 | 0.0219 |
| Example 15 | C | 30 | 1.52 | 1.42 | B | Pillar pattern | 4 | 1 | 1.58 | B | 161.4 | 150.1 | 0.0226 |
| Example 16 | A | - | 1.52 | - | B | Pillar pattern | 1 | 1 | 1.58 | B | 167.3 | 145.1 | 0.0391 |
| Example 17 | A | - | 1.52 | - | B | Pillar pattern | 2 | 1 | 1.58 | B | 161.8 | 140.6 | 0.0320 |
| Example 18 | A | - | 1.52 | - | B | Pillar pattern | 4 | 1 | 1.58 | B | 169.8 | 145.5 | 0.0331 |
| Example 19 | C | 30 | 1.52 | 1.42 | B | Grid pattern | 2 | 0.4 | 1.58 | B | 139.5 | 132.6 | 0.0013 |
| Example 20 | C | 30 | 1.52 | 1.42 | B | Grid pattern | 2 | 0.8 | 1.58 | B | 143.6 | 136.0 | 0.0048 |
| Example 21 | C | 30 | 1.52 | 1.42 | B | Grid pattern | 2 | 1.2 | 1.58 | B | 146.1 | 136.3 | 0.0073 |
| Example 22 | A | - | 1.52 | - | B | Grid pattern | 2 | 0.4 | 1.58 | B | 149.0 | 141.0 | 0.0297 |
| Example 23 | A | - | 1.52 | - | B | Grid pattern | 2 | 0.8 | 1.58 | B | 148.1 | 141.4 | 0.0299 |
| Example 24 | A | - | 1.52 | - | B | Grid pattern | 2 | 1.2 | 1.58 | B | 149.4 | 142.1 | 0.0288 |

### [Examples 25 to 28]

The surface light-emitting bodies were obtained by conducting an operation in the same manner as in Example 8 except that the kind of the active energy ray-curable composition and the thickness of the intermediate layer were changed. The light extraction efficiency, normal brightness, and quantity of change in chromaticity of the surface light-emitting bodies thus obtained are presented in Table 4.

**[Table 4]**

| | Relief structure layer | | | | Diffraction grating layer | | | | | Kind of organic EL light-emitting element | Surface light-emitting body | | |
|---|---|---|---|---|---|---|---|---|---|---|---|---|---|
| | Kind of composition | Content of fine particles (%) | Refractive index of resin | Refractive index of fine particles | Kind of composition | Shape of diffraction grating | Pitch of diffraction grating (mm) | Depth of diffraction grating (mm) | Refractive index of resin | | Light extraction efficiency (%) | Normal brightness (%) | Quantity of change in chromaticity |
| Reference Example 1 | - | - | - | - | - | - | - | - | - | A | 100 | 100 | 0.0240 |
| Example 25 | D | 10 | 1.52 | 1.42 | B | Grid pattern | 2 | 0.8 | 1.58 | A | 151.7 | 160.4 | 0.0035 |
| Example 26 | D | 10 | 1.52 | 1.42 | B | Grid pattern | 2 | 0.8 | 1.58 | A | 180.3 | 161.0 | 0.0030 |
| Example 27 | E | 20 | 1.52 | 1.42 | B | Grid pattern | 2 | 0.8 | 1.58 | A | 181.9 | 164.4 | 0.0021 |
| Example 28 | E | 20 | 1.52 | 1.42 | B | Grid pattern | 2 | 0.8 | 1.58 | A | 181.0 | 164.6 | 0.0021 |

### [Examples 29 to 32]

The surface light-emitting bodies were obtained by conducting an operation in the same manner as in Example 20 except that the kind of the active energy ray-curable composition and the thickness of the intermediate layer were changed. The light extraction efficiency, normal brightness, and quantity of change in chromaticity of the surface light-emitting bodies thus obtained are presented in Table 5.

**[Table 5]**

| | Relief structure layer | | | | Diffraction grating layer | | | | | Kind of organic EL light-emitting element | Surface light-emitting body | | |
|---|---|---|---|---|---|---|---|---|---|---|---|---|---|
| | Kind of composition | Content of fine particles (%) | Refractive index of resin | Refractive index of fine particles | Kind of composition | Shape of diffraction grating | Pitch of diffraction grating (mm) | Depth of diffraction grating (mm) | Retractive index of resin | | Light extraction efficiency (%) | Normal brightness (%) | Quantity of change in chromaticity |
| Reference Example 2 | - | - | - | - | - | - | - | | - | B | 100 | 100 | 0.0159 |
| Example 29 | D | 10 | 1.52 | 1.42 | B | Grid pattern | 2 | 0.8 | 1.58 | B | 152.4 | 136.5 | 0.0108 |
| Example 30 | D | 10 | 1.52 | 1.42 | B | Grid pattern | 2 | 0.8 | 1.58 | B | 152.1 | 135.9 | 0.0099 |
| Example 31 | E | 20 | 1.52 | 1.42 | B | Grid pattern | 2 | 0.8 | 1.58 | B | 151.9 | 133.9 | 0.0075 |
| Example 32 | E | 20 | 1.52 | 1.42 | B | Grid pattern | 2 | 0.8 | 1.58 | B | 151.8 | 133.9 | 0.0074 |

### INDUSTRIAL APPLICABILITY

By the optical film of the invention, it is possible to obtain a surface light-emitting body which achieves both an improvement in light extraction efficiency or normal brightness and the suppression of exiting angle dependency of the exited light wavelength, and this surface light-emitting body can be suitably used, for example, in lighting, a display, and a screen.

### EXPLANATIONS OF LETTERS OR NUMERALS

- 10: Optical film
- 11: Surface relief structure layer
- 12: Diffraction grating layer
- 13: Intermediate layer
- 14: Relief structure
- 15: Fine particles
- 16: Resin
- 17: Bottom surface portion of relief structure
- 18: Substrate
- 21: Pressure sensitive adhesive layer
- 22: Protective film
- 30: EL light-emitting device
- 31: Glass substrate
- 32: Anode
- 33: Light-emitting layer
- 34: Cathode

## Claims

1. An optical film comprising:
a surface relief structure layer that is composed of a first transparent material and has a relief structure; and
a diffraction grating layer composed of a second transparent material.

2. The optical film according to claim 1, wherein the second transparent material is a resin.

3. The optical film according to claim 1 or 2, wherein a refractive index of the second transparent material is from 1.30 to 1.80.

4. The optical film according to any one of claims 1 to 3, wherein a pitch of a diffraction grating of the diffraction grating layer is from 0.2 to 5 µm.

5. The optical film according to any one of claims 1 to 4, wherein a height of a diffraction grating of the diffraction grating layer is from 0.4 to 5 µm.

6. The optical film according to any one of claims 1 to 5, wherein the first transparent material is a resin.

7. The optical film according to any one of claims 1 to 6, wherein the relief structure of the surface relief structure layer is spherical.

8. The optical film according to any one of claims 1 to 7, wherein the surface relief structure layer further contains light-diffusing fine particles.

9. The optical film according to claim 8, wherein a volume average particle size of the light-diffusing fine particles is from 1 to 10 µm.

10. The optical film according to claim 8 or 9, wherein a content of the light-diffusing fine particles in the surface relief structure layer is from 1 to 50% by mass.

11. The optical film according to any one of claims 1 to 10, wherein a difference in refractive index between the second transparent material and the first transparent material is from 0.01 to 0.30.

12. The optical film according to any one of claims 1 to 11, wherein a ratio of a pitch of the relief structure of the surface relief structure layer to a pitch of a diffraction grating of the diffraction grating layer is from 10 to 100.

13. The optical film according to any one of claims 1 to 12, wherein the optical film further comprises a substrate, and the diffraction grating layer and the surface relief structure layer are sequentially stacked on the substrate.

14. A surface light-emitting body comprising the optical film according to any one of claims 1 to 13.

15. The surface light-emitting body according to claim 14, wherein the surface light-emitting body further comprises an EL light-emitting device fabricated by sequentially stacking a cathode, a light-emitting layer, an anode, and a substrate, and the optical film is stacked on the substrate of the EL light-emitting device so that the surface relief structure layer becomes a light-exiting surface.

16. A optical film manufacturing method comprising:
supplying a second active energy ray-curable composition between a substrate and a die having a transfer portion of a diffraction grating and irradiating the composition with a second active energy ray to obtain a stacked body having a diffraction grating layer on the substrate; and
supplying a first active energy ray-curable composition between the stacked body thus obtained and a die having a transfer portion of a relief structure and irradiating the composition with a first active energy ray.
